# EUROPEAN PATENT SPECIFICATION

(11) **EP 2 801 645 B1**
(45) Date of publication and mention of the grant of the patent: **27.02.2019**
(21) Application number: 12849124.8
(22) Date of filing: 12.11.2012
(51) Int. Cl.: C30B 29/16, C30B 15/34, C30B 15/36

(54) **METHOD FOR GROWING BETA-GA2O3 BASED SINGLE CRYSTAL**
VERFAHREN ZUR ZÜCHTUNG VON BETA-GA2O3-BASIERTEN EINKRISTALLEN
PROCÉDÉ DE DÉVELOPPEMENT D'UN MONOCRISTAL À BASE DE BETA-GA2O3

(30) Priority: 15.11.2011 JP 2011249891
(43) Date of publication of application: 12.11.2014
(73) Proprietor: Tamura Corporation, Tokyo 178-8511 (JP); Koha Co., Ltd., Tokyo 176-0022 (JP)
(72) Inventor: KOSHI, Kimiyoshi, Tokyo 176-0022 (JP); MATSUBARA, Haruka, Tokyo 178-8511 (JP); WATANABE, Shinya, Tokyo 178-8511 (JP)
(74) Representative: TBK
(86) International application number: PCT/JP2012/079265
(87) International publication number: WO 2013/073497

(56) References cited:
- EP-A2- 1 367 657
- JP-A- 2001 181 091
- JP-A- 2001 181 091
- JP-A- 2004 262 684
- JP-A- 2006 312 571
- JP-A- 2011 153 054
- JP-A- 2011 190 134
- US-A- 4 121 965

## Description

### [Technical Field]

The invention relates to a method for growing a β-Ga**₂**O**₃** based single crystal and, in particular, to a method for growing a β-Ga**₂**O**₃** based single crystal which is capable of effectively controlling the twinning of crystal.

### [Background Art]

A crystal growth method is known in which an InP single crystal having substantially the same size as a seed crystal is grown by the Bridgman method (see, e.g. NPL **1**). According to the method disclosed in NPL **1,** it is possible to obtain an InP single crystal without twins.

However, in growing a single crystal by the Bridgman method, it is necessary to remove the single crystal from a crucible after the crystal growth. If the crucible is formed of a material having a high adhesion to the crystal, it is difficult to remove the grown single crystal therefrom.

Another crystal growth method is known in which a Si single crystal having substantially the same size as a seed crystal is grown by an EFG (Edge-defined film-fed growth) method (see PL 1).

Crystal growth methods are known in which a β-Ga₂O₃ based single crystal is grown by the EFG method (see PL 2 and PL 3).

### [Citation List]

### [Non Patent Literature]

NPL 1: F. Matsumoto et al., Journal of Crystal Growth, 132 (1993), pp.348-350

### [Patent Literature]

PL 1: US 4 121 965 A
PL 2: EP 1 367 657 A2
PL 3: JP 2006-312571 A

### [Summary of Invention]

### [Technical Problem]

In case of growing a Ga₂O₃ crystal, a crucible formed of Ir is generally used but Ir has a high adhesion to a β-Ga₂O₃ based single crystal. Therefore, it is difficult to remove the single crystal from the crucible when the β-Ga₂O₃ based single crystal is grown by the Bridgman method.

Further, it is difficult to control the twinning of crystal when the β-Ga₂O₃ based single crystal is grown by the EFG method.

It is an object of the invention to provide a method for growing a β-Ga**₂**O**₃** based single crystal that allows the β-Ga**₂**O**₃** based single crystal to be obtained while controlling the twinning of crystal.

### [Solution to Problem]

According to one embodiment of the invention, a method for growing a β-Ga**₂**O**₃** based single crystal as defined in claim 1 is provided so as to achieve the above object.

### [Advantageous Effects of Invention]

According to one embodiment of the invention, a method for growing a β-Ga**₂**O**₃** based single crystal can be provided that allows the β-Ga**₂**O**₃** based single crystal to be obtained while controlling the twinning of crystal.

### [Brief Description of Drawings]

**FIG1** is a vertical cross sectional view showing a part of an EFG crystal manufacturing apparatus in an embodiment.
**FIG.2** is a perspective view showing a state during growth of a β-Ga**₂**O**₃** based single crystal.
**FIG.3A** is a partially enlarged view showing the vicinity of a boundary between a seed crystal (width: W**₁**) and a β-Ga**₂**O**₃** based single crystal (width: W**₂**) in the embodiment (in case of W**₁**=W**₂**).
**FIG.3B** is a partially enlarged view showing the vicinity of a boundary between a seed crystal (width: W**₁**) and a β-Ga**₂**O**₃** based single crystal (width: W**₂**) in the embodiment (in case of W**₁**W**₂**).
**FIG.3C** is a partially enlarged view showing the vicinity of a boundary between a seed crystal (width: W**₁**) and a β-Ga**₂**O**₃** based single crystal (width: W**₂**) in the embodiment (in case of W**₁**<W**₂**).
**FIG.4** is a partially enlarged view showing a crystal seed having a neck portion in the vicinity of the boundary and a β-Ga**₂**O**₃** based single crystal in Comparative Example.

### [Description of Embodiments]

In the present embodiment, a β-Ga**₂**O**₃** based single crystal is grown by the EFG (Edge-defined film-fed growth) method without performing a necking process or a process of greatly broadening a shoulder.

The necking process is a process to form a thin neck portion at the time of bringing a seed crystal into contact with a melt of crystal raw material. After forming the neck portion, a crystal is grown while increasing a width to the desired size (a shoulder broadening process) and the crystal is then grown while keeping the desired width.

Dislocations in the seed crystal can be prevented from being passed to a grown crystal by performing the necking process. However, when the necking process is performed during growing a β-Ga**₂**O**₃** based single crystal, the twin is likely to be formed in the process of greatly broadening a shoulder after the necking process.

It is possible to control the twinning of crystal by rapidly cooling the β-Ga**₂**O**₃** based single crystal after the necking process by e.g. a method of increasing a pulling speed of the crystal. However, a crack may be generated in the β-Ga**₂**O**₃** based single crystal due to the thermal shock.

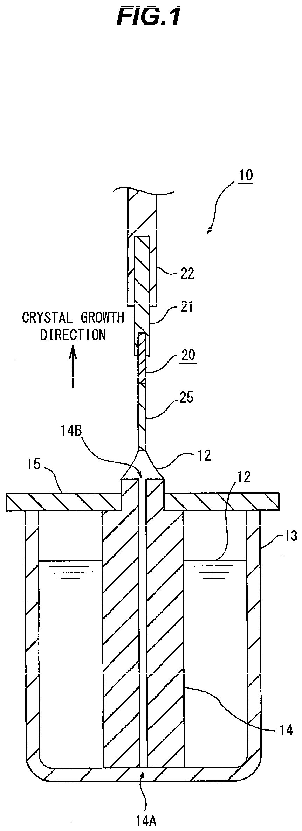

**FIG.1** is a vertical cross sectional view showing a part of an EFG crystal manufacturing apparatus in the embodiment. This EFG crystal manufacturing apparatus **10** has a crucible **13** containing a Ga**₂**O**₃** based melt **12,** a die **14** placed in the crucible **13** and having a slit **14**A, a lid **15** covering the upper surface of the crucible **13** except an opening **14**B of the slit **14**A, a crystal seed holder **21** for holding a β-Ga**₂**O**₃** based seed crystal (hereinafter, referred as "seed crystal") **20** and a shaft **22** vertically movably supporting the crystal seed holder **21.**

The crucible **13** contains the Ga**₂**O**₃** based melt **12** which is obtained by melting β-Ga**₂**O**₃** based powder. The crucible **13** is formed of a metal material having sufficient heat resistance to contain the Ga**₂**O**₃** based melt **12,** such as iridium.

The die **14** has the slit **14**A to draw up the Ga**₂**O**₃** based melt **12** by capillary action.

The lid **15** prevents the high-temperature Ga**₂**O**₃** based melt **12** from evaporating from the crucible **13** and further prevents the vapor of the Ga**₂**O**₃** based melt **12** from attaching to a portion other than the upper surface of the slit **14**A.

The seed crystal **20** is moved down and is brought into contact with the Ga**₂**O**₃** based melt **12** which is drawn up by capillary action. Then, the seed crystal **20** in contact with the Ga**₂**O**₃** based melt **12** is pulled up, thereby growing a plate-like β-Ga**₂**O**₃** based single crystal **25.** The crystal orientation of the β-Ga**₂**O**₃** based single crystal **25** is the same as the crystal orientation of the seed crystal **20** and, for example, a plane orientation and an angle in a horizontal plane of the bottom surface of the seed crystal **20** are adjusted to control the crystal orientation of the β-Ga**₂**O**₃** based single crystal **25.**

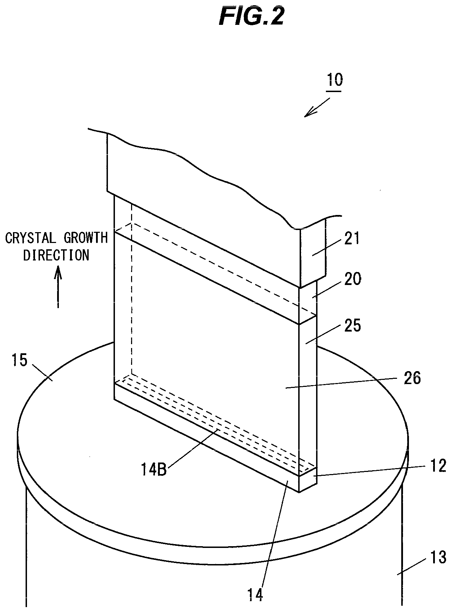

**FIG.2** is a perspective view showing a state during growth of a β-Ga**₂**O**₃** based single crystal. A surface **26** in **FIG.2** is a principal surface of the β-Ga**₂**O**₃** based single crystal **25** which is parallel to a slit direction of the slit **14**A. When a β-Ga**₂**O**₃** based substrate is formed by cutting out from the grow β-Ga**₂**O**₃** based single crystal **25,** the plane orientation of the surface **26** of the β-Ga**₂**O**₃** based single crystal **25** is made to coincide with the desired plane orientation of the principal surface of the β-Ga**₂**O**₃** based substrate. When forming a β-Ga**₂**O**₃** based substrate of which principal surface is e.g., a **(101)** plane, the plane orientation of the surface **26** is **(101).** The grown β-Ga**₂**O**₃** based single crystal **25** also can be used as a seed crystal for growing a new β-Ga**₂**O**₃** based single crystal.

The β-Ga**₂**O**₃** based single crystal **25** and the seed crystal **20** are β-Ga**₂**O**₃** single crystals, or are β-Ga**₂**O**₃** single crystals with an element such as Cu, Ag, Zn, Cd, Al, In, Si, Ge or Sn added thereto. The β-Ga**₂**O**₃** crystal has a β-gallia structure belonging to the monoclinic system and typically has lattice constants of a**₀**=**12.23**Å, b₀=**3.04**Å, c₀=**5.80**Å, α=γ=**90**° and β=**103.8**°.

A twin crystal formed during growth of the β-Ga**₂**O**₃** based single crystal is composed of two mirror-symmetrical β-Ga**₂**O**₃** based crystals. The planes of symmetry of the β-Ga**₂**O**₃** based crystal twin (twin planes) are **(100)** planes. When the β-Ga**₂**O**₃** based single crystal is grown by the EFG method, the twin is likely to be formed in the process of greatly broadening a shoulder after the necking process.

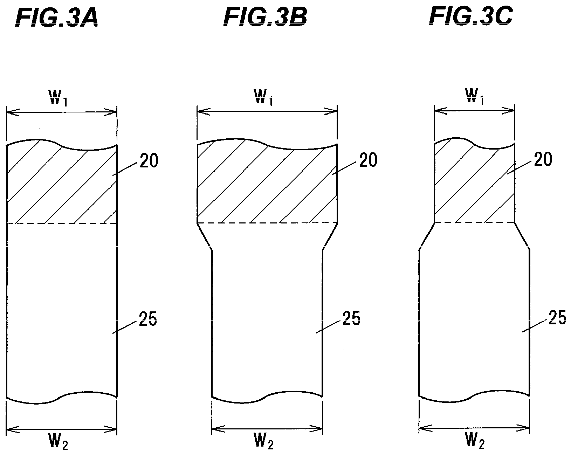

**FIGS.3A** to **3C** are partially enlarged views showing the vicinity of a boundary between a seed crystal and a β-Ga**₂**O**₃** based single crystal in the present embodiment. W**₁**=W**₂** in **FIG.3A****,** W**₁**>W**₂** in **FIG.3B** and W**₁**<W**₂** in **FIG.3C** where W**₁** and W**₂** are respectively the width of the seed crystal **20** and that of the β-Ga**₂**O**₃** based single crystal **25.**

In any of **FIGS.3A** to **3C****,** a neck portion formed by the necking process is not present in the vicinity of the boundary between the seed crystal **20** and the β-Ga**₂**O**₃** based single crystal **25.** Therefore, the β-Ga**₂**O**₃** based single crystal **25** does not contain twins or only contains a trace amount of twins. Note that, there is a tendency that crystal twinning proceeds with an increase in a ratio of W**₂** to W**₁** even in the case that the necking process is not performed. Therefore, W**₂** is required to be not more than **110**% of W₁.

In addition, the above-mentioned relation between W**₂** and W₁ is true for the widths of the seed crystal **20** and the β-Ga**₂**O**₃** based single crystal **25** in all directions. In other words, in the present embodiment, the width of the β-Ga**₂**O**₃** based single crystal **25** is not more than **110**% of the width of the seed crystal **20** in all directions.

Furthermore, in order to control the twinning of crystal in the β-Ga**₂**O**₃** based single crystal **25** more effectively, the width of the β-Ga**₂**O**₃** based single crystal **25** is preferably not more than **100**% of the width of the seed crystal **20** in all directions. More preferably, the width of the β-Ga**₂**O**₃** based single crystal **25** is equal to the width of the seed crystal **20** in all directions.

The width W₂ of the β-Ga**₂**O**₃** based single crystal **25** with respect to the width W**₁** of the seed crystal **20** can be controlled by, e.g., a temperature condition during growth of the β-Ga**₂**O**₃** based single crystal **25.** In this case, the lower the temperature during growth of the β-Ga**₂**O**₃** based single crystal **25,** the greater the width W₂.

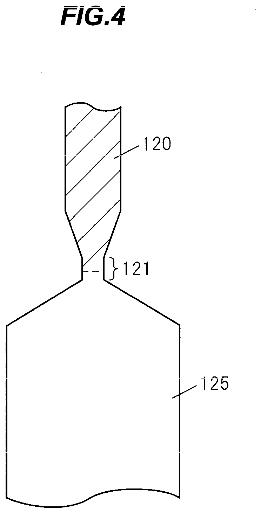

**FIG.4** is a partially enlarged view showing a crystal seed having a neck portion in the vicinity of the boundary and a β-Ga**₂**O**₃** based single crystal in Comparative Example. A neck portion **121** is present in the vicinity of the boundary between a seed crystal **120** and a β-Ga**₂**O**₃** based single crystal **125.** The β-Ga**₂**O**₃** based single crystal **125** is formed through the process of greatly broadening a shoulder after the necking process and thus often contains many twins.

When the β-Ga**₂**O**₃** based single crystal **125** is grown in, e.g., the b-axis direction, the average number of twins on the principal surface (a surface parallel to the page surface) per **1** cm in a direction perpendicular to the b-axis is **30.7** to **37.0.**

On the other hand, in the present embodiment, it is possible to form the β-Ga**₂**O**₃** based single crystal **25** in which the average number of twins on the surface **26** per **1** cm in a direction perpendicular to the b-axis is substantially zero even when the β-Ga**₂**O**₃** based single crystal **25** is grown in the b-axis direction.

An example of a growth condition of the β-Ga**₂**O**₃** based single crystal **25** in the present embodiment will be described below.

The β-Ga**₂**O**₃** based single crystal **25** is grown in, e.g., a nitrogen atmosphere.

The seed crystal **20** is substantially the same size or larger than the β-Ga**₂**O**₃** based single crystal **25** and is thus larger than a crystal seed used for typical crystal growth and is fragile to thermal shock. Therefore, a height of the seed crystal **20** from the die **14** before contact with the Ga**₂**O**₃** based melt **12** is preferably low to some extent and is, e.g., **10** mm. In addition, a descending speed of the seed crystal **20** until the contact with the Ga**₂**O**₃** based melt **12** is preferably low to some extent and is, e.g., **1** mm/min.

Standby time until pulling up the seed crystal **20** after the contact with the Ga**₂**O**₃** based melt **12** is preferably long to some extent in order to further stabilize the temperature to prevent thermal shock, and is, e.g., **10** min.

A temperature rise rate at the time of melting a raw material in the crucible **13** is low to some extent in order to prevent a rapid increase in temperature around the crucible **13** and resulting thermal shock on the seed crystal **20,** and the raw material is melted over, e.g., **11** hours.

### (Effects of the embodiment)

In the present embodiment, the Ga**₂**O**₃** based single crystal is grown without performing the necking or the process of greatly broadening a shoulder, which can effectively control the twinning of crystal in the β-Ga**₂**O**₃** based single crystal.

In general, in case of growing a β-Ga**₂**O**₃** based single crystal by the EFG method, the crystal is likely to be twinned especially when the crystal is grown in the b-axis direction thereof. However, in the present embodiment, it is possible to control the twinning of crystal even if the β-Ga**₂**O**₃** based single crystal is grown in the b-axis direction.

Although the embodiment of the invention has been described above, the invention according to claims is not to be limited to the above-mentioned embodiment. Further, please note that all combinations of the features described in the embodiment are not necessary to solve the problem of the invention.

### [Industrial Applicability]

It is possible to provide a method for growing a β-Ga**₂**O**₃** based single crystal which is capable of effectively controlling the twinning of crystal.

### [Reference Signs List]

**10** EFG crystal manufacturing apparatus
**20** crystal seed
**25** β-Ga**₂**O**₃** based single crystal

## Claims

1. A method for growing a plate-shaped β-Ga₂O₃ based single crystal using an EFG method, comprising:
a step of bringing a plate-shaped seed crystal into contact with a Ga₂O₃ based melt; and
a step of pulling the plate-shaped seed crystal to grow a plate-shaped β-Ga₂O₃ based single crystal in a b-axis direction without conducting a necking process,
wherein a width of the plate-shaped β-Ga₂O₃ based single crystal in any direction perpendicular to the b-axis direction is not more than 110% of a width of the plate-shaped seed crystal in that direction perpendicular to the b-axis direction.

2. The method for growing a β-Ga₂O₃ based single crystal according to claim 1, wherein the width of the plate-shaped β-Ga₂O₃ based single crystal is not more than 100% of the width of the plate-shaped seed crystal.

3. The method for growing a β-Ga₂O₃ based single crystal according to claim 2, wherein the width of the plate-shaped β-Ga₂O₃ based single crystal is equal to the width of the plate-shaped seed crystal.

## Patentansprüche

1. Verfahren zum Züchten eines plattenförmigen, auf β-Ga₂O₃ basierenden Einkristalls unter Verwendung eines EFG-Verfahrens, mit:
einem Schritt, in dem ein plattenförmiger Impfkristall mit einer auf Ga₂O₃ basierenden Schmelze in Kontakt gebracht wird; und
einem Schritt, in dem der plattenförmige Impfkristall gezogen wird, um einen plattenförmigen, auf β-Ga₂O₃ basierenden Einkristall in einer b-Achsenrichtung zu züchten, ohne einen Einschnürungsvorgang durchzuführen,
wobei eine Breite des plattenförmigen, auf β-Ga₂O₃ basierenden Einkristalls in jeglicher Richtung senkrecht zu der b-Achsenrichtung nicht mehr als 110% einer Breite des plattenförmigen Impfkristalls in dieser zur b-Achsenrichtung senkrechten Richtung beträgt.

2. Verfahren zum Züchten eines auf β-Ga₂O₃ basierenden Einkristalls nach Anspruch 1, wobei die Breite des plattenförmigen, auf β-Ga₂O₃ basierenden Einkristalls nicht mehr als 100% der Breite des plattenförmigen Impfkristalls beträgt.

3. Verfahren zum Züchten eines auf β-Ga₂O₃ basierenden Einkristalls nach Anspruch 2, wobei die Breite des plattenförmigen, auf β-Ga₂O₃ basierenden Einkristalls gleich der Breite des plattenförmigen Impfkristalls ist.

## Revendications

1. Procédé de croissance d'un monocristal à base de β-Ga₂O₃ en forme de plaque utilisant un procédé EFG, comprenant :
une étape de mise en contact d'un cristal de germe en forme de plaque avec une matière fondue à base de Ga₂O₃ ; et
une étape de croissance du cristal de germe en forme de plaque pour faire croître un monocristal à base de β-Ga₂O₃ en forme de plaque dans une direction d'axe b sans conduire un processus de striction,
dans lequel une largeur du monocristal à base de β-Ga₂O₃ en forme de plaque dans une direction quelconque perpendiculaire à la direction de l'axe b n'est pas supérieure à 110 % d'une largeur du cristal de germe en forme de plaque dans cette direction perpendiculaire à la direction d'axe b.

2. Procédé de croissance d'un monocristal à base de β-Ga₂O₃ selon la revendication 1, dans lequel la largeur du monocristal à base de β-Ga₂O₃ en forme de plaque n'est pas supérieure à 100 % de la largeur du cristal de germe en forme de plaque.

3. Procédé de croissance d'un monocristal à base de β-Ga₂O₃ selon la revendication 2, dans lequel la largeur du monocristal à base de β-Ga₂O₃ en forme de plaque est égale à la largeur du cristal de germe en forme de plaque.
